(19) Europäisches Patentamt

European Patent Office

Office européen des brevets

(11) **EP 0 714 866 B1**

(12) **EUROPÄISCHE PATENTSCHRIFT**

(45) Veröffentlichungstag und Bekanntmachung des Hinweises auf die Patenterteilung:
**12.05.1999 Patentblatt 1999/19**

(51) Int. Cl.⁶: **C04B 35/499**, H01P 7/10, H01L 41/187

(21) Anmeldenummer: **95203188.8**

(22) Anmeldetag: **21.11.1995**

(54) **Komplexer, substituierter Lanthan-Blei-Zirkon-Titan-Perowskit, keramische Zusammensetzung und Aktuator**

Complex, substituted lanthanum-lead-zirconium-titanium-perovskite, ceramic composition and actuator

Composition céramique de type perovskite complexe substituée lanthane-plomb-zirconium-titane et actuateur

(84) Benannte Vertragsstaaten:
**DE FR GB NL**

(30) Priorität: **30.11.1994 DE 4442598**

(43) Veröffentlichungstag der Anmeldung:
**05.06.1996 Patentblatt 1996/23**

(73) Patentinhaber:
• **Philips Patentverwaltung GmbH**
**22335 Hamburg (DE)**
Benannte Vertragsstaaten:
**DE**
• **Koninklijke Philips Electronics N.V.**
**5621 BA Eindhoven (NL)**
Benannte Vertragsstaaten:
**FR GB NL**

(72) Erfinder:
**Chen, Zhien-Chi,**
**c/o Philips**
**D-22335 Hamburg (DE)**

(74) Vertreter:
**Volmer, Georg, Dipl.-Ing. et al**
**Philips Patentverwaltung GmbH,**
**Röntgenstrasse 24**
**22335 Hamburg (DE)**

(56) Entgegenhaltungen:
**DE-A- 2 744 208        DE-A- 4 005 507**

• **DATABASE WPI Week 9316 Derwent Publications Ltd., London, GB; AN 93-131150 & JP-A-05 070 225 (HITACHI METALS KK) , 23.März 1993**
• **NEC RESEARCH AND DEVELOPMENT, Nr. 85, April 1987 TOKYO, JAPAN, Seiten 1-5, M. YONEZAWA ET AL. 'A NEW LOW-FIRING X7R MULTILAYER CERAMIC CAPACITORS.'**

**Beschreibung**

Die Erfindung bezieht sich auf einen komplexen, substituierten Lanthan-Blei-Zirkon-Titan-Perowskit sowie auf eine piezoelektrische, keramische Zusammensetzung und einen Aktuator.

In der elektronischen Industrie besteht heute ein wachsender Bedarf an Bauelementen, die elektronisch gesteuert kleine mechanische Verstellungen ausführen können, z. B. für Tintenstrahl- und Nadeldrucker, für die Brennstoffeinspritzung in Autos, Laufwerke, den Autofokus von Kameras und ähnliches. Bauelemente, die dies können, werden als "Aktuatoren" bezeichnet. Sie werden aus piezoelektrischen, keramischen Materialien hergestellt. Aktuatoren verlängern oder verkürzen sich unter dem Einfluß eines elektrischen Feldes. Sie werden bildhaft auch als die "Muskeln der Mikroelektronik" bezeichnet.

Es ist bekannt, als piezoelektrische, keramische Werkstoffe komplexe, mehrfach substituierte Blei-Zirkon-Titan-Perowskite (PZT) zu verwenden. Beispielsweise ist aus der EP 0 423 822 A1 eine ferroelektrische, d.h. im engeren Sinne piezoelektrische Keramik bekannt, die ein Perowskitmischkristall ist und die einen Mischkristall (Feste Lösung) umfaßt, mit der Formel

$Pb_{1-(3/2)a}M_a\{(Ni_{1/3}Nb_{2/3})_{1-b}(Zn_{1/3}Nb_{2/3})_b\}_xTi_yZr_zO_3$, wobei M mindestens ein Element aus der Gruppe, die aus La und Nd besteht, ist und $x + y + z$ gleich 1 ist, a Werte von 0,005 bis 0,03, b Werte von 0,5 bis 0,95, x Werte von 0,1 bis 0,4, y Werte von 0,3 bis 0,5 und z Werte von 0,2 bis 0,5 haben kann und die $MnO_2$ in einer Menge von 0,3 bis 1,0 Gew.-% des Perowskitmischkristalls enthält.

Weiterhin ist aus der NL-A- 6714565 ein Verfahren zur Herstellung von piezoelektrischem, keramischem Material bekannt, bei dem man ein Material der Zusammensetzung

$(Pb(Mg.W)_{1/2}O_3)_x$-$(PbTiO_3)_y$ mit $(PbZrO_3)_{(1-x-y)}$

mit solchen Werten für x und y zubereitet, das die Zusammensetzung in dem Dreiphasendiagramm

$Pb(Mg.W)_{1/2}O_3$ - $PbTiO_3$ - $PbZrO_3$

innerhalb des Vielecks ABCDEFGA liegt, das durch die folgende Tabelle definiert ist:

|   | $Pb(Mg.W)_{1/2}O_3$ | $PbTiO_3$ | $PbZrO_3$ |
|---|---|---|---|
|   | mol% | mol% | mol% |
| A | 0.05 | 0.15 | 0.80 |
| B | 0.05 | 0.35 | 0.60 |
| C | 0.05 | 0.55 | 0.40 |
| D | 0.05 | 0.80 | 0.15 |
| E | 0.10 | 0.80 | 0.10 |
| F | 0.10 | 0.10 | 0.10 |
| G | 0.10 | 0.10 | 0.80 |
| A | 0.05 | 0.15 | 0.80 |

Das Gemenge der 3 Komponenten wird gemischt und vermahlen, gepresst, langsam aufgeheizt und 3 h bei 1100-1200°C geglüht, danach 1 h bei 1200-1300 °C geglüht und abgekühlt. In die Ausgangsmischung kann zusätzlich 0,1- 5 Gewichtsprozent von mindestens einem der Oxide des Eisens, Chroms, Mangans oder der Seltenen Erdmetalle, beispielsweise Lanthan, oder Niob aufgenommen werden.

Die technischen Parameter, die für Aktuatoren von Bedeutung sind, sind die sogenannten piezoelektrischen Kleinsignalparameter. Es sind dies die Ladungskonstante d, die das Verhältnis zwischen relativer mechanischer Dehnung S und angelegter Feldstärke E gemäß $S = d*E$ angibt, der Kopplungsfaktor k, dessen Quadrat $k^2$ ein Maß für die Umsetzung elektrischer in mechanische Energie ist und die Dielektrizitätszahl $\varepsilon/\varepsilon_0$. Weiterhin sind von Bedeutung der dielektrische Verlustfaktor $\tan \delta$ und der Gütefaktor für radiale Schwingungen $Q_m^E$.

Diese Kleinsignalparameter sind material- und temperaturabhängig. Es gibt "harte" und "weiche" piezoelektrische Oxidkeramiken. "Weiche" Piezokeramiken haben einen niedrigen Gütefaktor für radiale Schwingungen, sie dämpfen angelegte Schwingungen und eignen sich für quasistatische Anwendungen. Harte Piezokeramiken haben niedrige Verlustfaktoren und hohe Gütefaktoren mit Werten > 100. Sie werden bevorzugt für Hochfrequenzanwendungen eingesetzt.

Die bekannten harten Piezokeramiken verändern ihre Eigenschaften unter Gleichstrombedingungen (R.

Waser, T. Baiatu und K.H. Härdtl, J. Am. Ceram. Soc. 73 (1990), 1645). Außerdem sintern die bekannten harten Piezo-oxide erst bei sehr hohen Temperaturen. Das macht sie ungeeignet für Vielschichtaktuatoren, für die Elektroden und Piezokeramik als gemeinsames Vielschichtstapelpaket gesintert werden müssen.

Es ist die Aufgabe der vorliegenden Erfindung einen komplexen, substituierten Lanthan-Blei-Zirkon-Titan- Pe rowskit zu schaffen, der eine piezoelektrisch harte Keramik ergibt, die im Gleichstrom nicht degradiert und bei niedrigen Temperaturen sintert.

Die Lösung dieser Aufgabe gelingt durch einen Blei-Lanthan-Zirkon-Titan-Perowskit der Zusammensetzung $Pb_{1-a}La_a(Mg_{x/2}W_{x/2})Ti_yZr_2O_3$,

mit $0,01 \leq a \leq 0,05$; $0,01 \leq x \leq 0,06$; $0,4 \leq y \leq 0,5$ und $0,4 \leq z \leq 0,5$, wobei $x + y + z = 1$ ist, mit einer Dotierung von 0,5 - 2 Mol-% $MnO_2$.

Ein derartiges Material hat sehr gute harte piezoelektrische Eigenschaften z.B. einen niedrigen Verlustfaktor tan $\delta$ und einen hohen Qualitätsfaktor und es altert nicht unter Gleichstrombedingungen. Da es bei niedrigen Temperaturen sintert, können aus ihm Vielschichtaktuatoren gefertigt werden, die harte piezoelektrische Eigenschaften haben.

Durch die günstige Kombination von Eigenschaften kann er auch mit Vorteil zur Herstellung von einfachen Aktuatoren für Stellmotoren, Vibratoren, Hybridmotoren, außerdem für Sonare und Wandler verwendet werden.

Nach einer bevorzugten Ausführungsform ist a = 0,03 und x = 0,5.

Besonders bevorzugt ist es, wenn die Dotierung aus 1,6 Mol-% $MnO_2$ besteht. Ein derartiges Material hat einen besonders hohen Gütefaktor.

Die Erfindung betrifft auch eine keramische Zusammensetzung, die mindestens einen Lanthan-Blei-Zirkon-Titan-Perowskit nach der Erfindung sowie 0,1 bis 20 Mol-% bleihaltiges Sinterhilfsmittel enthält. Durch das bleihaltige Sinterhilfmittel wird eine Flüssigphasensinterung bewirkt.

Die Erfindung betrifft weiterhin einen Aktuator, insbesondere mit Vielschichtstruktur, mit mindestens einer Schicht, die einen erfindungsgemäßen komplexen,mangansubstituierten Lanthan-Blei-Zirkon-Titan-Perowskit nach der Erfindung enthält. Dieser Aktuator hat piezoelektrisch harte Eigenschaften und ist besonders langzeitstabil.

Im folgenden wird die Erfindung näher erläutert und es werden Ausführungsbeispiele angegeben.

Die Bezeichnung "Perowskit" leitet sich von dem Mineral Perowskit ab. Sie wird allgemein verwendet für Verbindungen mit der Zusammensetzung $ABO_3$ und einer kubischen oder pseudokubischen Kristallstruktur. In dieser Kristallstruktur besetzen die A-Ionen die Ecken eines Würfels und die B-Ionen das Zentrum des Würfels. Die Sauerstoffionen besetzen die Flächenmitten des Würfels.

Eine ideale Perowskit-Kristallstruktur haben nur einige wenige Verbindungen, z.B. das Mineral Perowskit $CaTiO_3$ selbst. Das weite Eigenschaftenspektrum der industriell gefertigten Perowskite beruht jedoch auf der Anpassungsfähigkeit der Perowskitstruktur, die viele, sowohl einfache als auch komplexe Strukturveränderungen erlaubt.

Bei den Variationen der Perowskitstruktur, die kein Symmetriezentrum in der Kristallstruktur enthalten, ist es möglich, ein Dipolmoment im Kristall zu erzeugen, indem man die Kristallite in ein elektrisches Feld bringt. Diese Variationen der Perowskitstruktur treten besonders bei den titanhaltigen Perowskiten $ATiO_3$ auf. Materialien, die polarisierbar sind und deren Polarisationsrichtungen sich mit Hilfe eines elektrischen Feldes verändern lassen, bezeichnet man als Ferroelektrika.

Die aus dem Symmetriezentrum herausgerückten Kationen verursachen die Piezoelektrizität einiger Titanate mit Perowskitstruktur. Wenn ein elektrisches Feld die Titanatome verschiebt, dann verändert bei diesen Titan-Perowskiten der gesamte Kristall seine Form, er wird dadurch in einer Richtung etwas länger. Umgekehrt entsteht ein elektrisches Feld, wenn der Kristall mechanisch verformt wird. Diese piezoelektrischen Eigenschaften ermöglichen es, diese Titan-Perowskite für die Umwandlung von mechanischer in elektrische Energie und umgekehrt einzusetzen. Die besten piezoelektrischen Eigenschaften haben feste Lösungen (Mis chkristalle) von Bleititanat mit Bleizirkonat sowie die sich von diesen ableitenden Substitutionsmischkristalle.

Weitere Substitutionen auf den A- oder B-Gitterplätzen von Blei-Zirkon-Titanat ergeben eine ganze Gruppe kommerziell wichtiger Perowskite, die man alle unter der Abkürzung "PZT" zusammenfaßt. Von besonderer Bedeutung sind die mit Lanthan substituierten "LPZTs".

Perowskite, die durch gekoppelte Substitution mit Ionen unterschiedlicher Wertigkeit auf einem Gitterplatz entstehen, bezeichnet man als "komplexe Perowskite".

Die erfindungsgemäßen komplexen, oxidischen Perowskitderivate leiten sich von den bekannten komplexen Lanthan-Blei-Zirkon-Titan-Phasen (LPZT), die durch gekoppelte Substitution mit Magnesium und Wolfram erhalten wurden, durch den Einbau von zusätzlichen Mangan-Kationen ab.

Es wird angenommen, daß diese Mangan-Kationen auf den B-Plätzen in das Perowskitgitter eingebaut werden.

Diese theoretische Überlegung dient aber nur dazu, die Erfindung zu erläutern und bildet nicht einen Teil des Erfindungsgedanken.

Die erfindungsgemäßen Perowskite können nach den herkömmlichen Methoden hergestellt werden. Eine Standardmethode ist die "Mixed Oxide"-Technik. Dazu werden zur Bildung einer Vormischung die binären Oxide der jeweiligen Kationen im molaren Verhältnis entsprechend der Formel zu einer Vormischung abgewogen. Sie werden in einer Kugelmühle naß vermahlen, z. B. in einem Achattiegel mit Achatkugeln von 10 mm Durchmesser und Cyclohexan als Lösungsmittel für 2 Stunden.

Die Vormischung kann aber auch durch Kopräzipitation, Sol-Gel-Verfahren oder Hydrothermalsynthese aus den entsprechenden Ausgangsverbindungen erhalten werden.

Nach dem Trocknen der Vormischung wird diese kalziniert, z. B. bei 800°C, 10h, mit einer Heiz- und Abkühlrate von 200°C/h.

Die Pulver können ohne Sinterhilfsmittel dicht gesintert werden. Es ist jedoch ein Aspekt der Erfindung, eine keramische Zusammensetzung zur Verfügung zu stellen, bei der die erfindungsgemäßen komplexen, substituierten Perowskite mit einem bleihaltigen Sinterhilfsmittel z.B. PbO und $PbZrO_3$ gemischt werden. Die Sinterhilfsmittel bewirken eine Flüssigphasensinterung der Ausgangspulver und bilden in der fertig gesinterten keramischen Zusammensetzung eine zweite Phase, die amorph oder kristallin sein kann und homogen verteilt ist.

Die kalzinierten Pulver oder die keramischen Zusammensetzungen mit einem Sinterhilfsmittel werden erneut 2h in einer Kugelmühle unter denselben Bedingungen gemahlen. Anschließend werden sie auf einer Rollenbank gemahlen, z.B. 20 h mit Cyclopropanol als Lösungsmittel und yttriumstabilisierten $ZrO_2$-Kugeln von 2 mm Durchmesser.

Diese Ausgangspulver werden zunächst auf einer Blockpresse vorgepreßt und dann isostatisch mit einem Preßdruck von 320 MPa fertiggepreßt. Die fertigen Preßkörper werden bei Sintertemperaturen von 1075°C bis 1100°C zwei Stunden in Sauerstoffatmosphäre auf $ZrO_2$- Unterlagen gesintert.

AUSFÜHRUNGSBEISPIELE

Beispiel 1

$Pb_{0,97}La_{0,03}Ti_{0,44}Zr_{0,46}Mg_{0,05}W_{0,05}O_3$ mit 1,6 mol-% $MnO_2$

Als Rohstoffe wurden Reagentien der Fa. Merck, Darmstadt, mit dem Reinheitsgrad "p.a." verwendet.

Die Ausgangsrohstoffe

216,49 g PbO,
4,88 g $La_2O_3$,
35,16 g $TiO_2$,
56,81 g $ZrO_2$,
10,79 g $WO_3$
2,02 g MgO und
1,39 g $MnO_2$

werden in Isopropanol suspendiert und in einer Achatkugelmühle 6 Stunden gemeinsam vermahlen. Nach dem Mahlen wird die Suspension unter einem Oberflächenverdampfer bei ca. 120°C getrocknet und anschließend in einem lose verschlossenen Sinterkorundtiegel 12 h bei 800°C an Luft vorgebrannt.

Das bei 800°C vorreagierte Pulvergemisch wird mit 345,09 g $PbZrO_3$ gemischt und ein zweites Mal in isopropanolischer Suspension 20 h in einer Kugelmühle mit yttriumstabilisierten $ZrO_2$-Kugeln (Durchmesser 2 mm) gemahlen. Das gemahlene Pulver wird kaltisostatisch mit einem Druck von 320 mPa zu prismatischen Körpern der Abmessung 6 x 6 x 15 $mm^3$ gepreßt.

Die Proben wurden mit 320°C/h auf 1100°C aufgeheizt und im Sauerstoffstrom bei 1100°C für 2 h gesintert. Als Unterlage dienen Platten aus stab. $ZrO_2$ oder aus demselben LPZT-Material. Es wurde eine Dichte von 98 % erreicht.

In der gleichen Art und Weise werden eine Reihe von weiteren mangandotierten LPZTs hergestellt, deren Zusammensetzung in Tabelle 1 angegeben ist.

Tab. 1

| Chemische Zusammensetzung | |
|---|---|
| NR. | CHEMISCHE ZUSAMMENSETZUNG |
| 1 | $Pb_{0,99}La_{0,01}Ti_{0,46}Zr_{0,49}Mg_{0,025}W_{0,025}O_3$ + 1,6 % $MnO_2$ |

Tab.1 (fortgesetzt)

| NR. | Chemische Zusammensetzung |
|---|---|
|  | CHEMISCHE ZUSAMMENSETZUNG |
| 2 | $Pb_{0,985}La_{0,015}Ti_{0,46}Zr_{0,44}Mg_{0,05}W_{0,05}O_3 + 1,6\ \%\ MnO_2$ |
| 3 | $Pb_{0,97}La_{0,03}Ti_{0,45}Zr_{0,50}Mg_{0,025}W_{0,025}O_3 + 1,6\ \%\ MnO_2$ |
| 4 | $Pb_{0,985}La_{0,015}Ti_{0,47}Zr_{0,48}Mg_{0,025}W_{0,025}O_3 + 0,8\ \%\ MnO_2$ |
| 5 | $Pb_{0,99}La_{0,01}Ti_{0,47}Zr_{0,48}Mg_{0,025}W_{0,025}O_3 + 0,8\ \%\ MnO_2$ |
| 6 | $Pb_{0,99}La_{0,01}Ti_{0,47}Zr_{0,49}Mg_{0,02}W_{0,02}O_3 + 1,6\ \%\ MnO_2$ |
| 7 | $Pb_{0,985}Gd_{0,015}Ti_{0,46}Zr_{0,49}Mg_{0,025}W_{0,025}O_3 + 0,8\ \%\ MnO_2$ |

Zur Bestimmung der relevanten piezoelektrischen Kleinsigalparameter der erfindungsgemäßen Keramik wurden aus der gesinterten Keramik Zylinder mit 5 mm Durchmesser geschliffen. Diese wurden zu Plättchen von 0,4 mm Dicke zersägt und geläppt. Dann wurden für die elektrischen Messungen auf beide Seiten der Plättchen Kontakte aus Au mit einer dünnen Haftschicht aus Ni/Cr aufgedampft.

Die dielektrischen und piezoelektrischen Eigenschaften wurden vor bzw. nach der Polarisation bestimmt. Zur Polarisation wurden die Scheiben unter Silikonöl 2 min. bei 150°C einem Feld von 0,35 kV/100 μm ausgesetzt.

Die relevanten piezoelektischen Kleinsignalparameter wurden mit Hilfe einer Impedanzmeßbrücke aus dem Resonanzverhalten der axial gepolten keramischen Scheibchen bestimmt. Dazu wurde ein Computerprogramm benutzt, mit dessen Unterstützung das Resonanzverhalten und die Kapazität dünner, runder, axial polarisierter Scheiben bestimmt werden kann.

Alle Messungen wurden mit einem Hewlett-Packard-4194-A Impedance Analyser mit Unterstützung durch einen HP-9000/-300 Rechner durchgeführt. Aus den so erhaltenen Meßwerten wurden die Dielektrizitätskonstanten und die Kleinsignalparameter berechnet. Die Ergebnisse sind in Tabelle 2 zusammengefaßt.

Außerdem wurde an Schliffen die Mikrostruktur der erfindungsgemäßen keramischen Zusammensetzungen untersucht.

Das Langzeitverhalten der keramischen Zusammensetzungen in Bezug auf ihren Gleichstromwiderstand wurde mit einem ALT-Test (Accelerated Life Test) bestimmt. Dafür wurde der Gleichstromwiderstand bei 250 °C und 1 V/μm gemessen.

Bei einem Material, das mit 0,8 Mol-% $MnO_2$ dotiert wurde, hat der Gleichstromwiderstand im ALT-Test nach 100 h noch einen Wert von 10% des ursprünglichen Wertes. Bei einem Material, das mit 1,6 Mol-% $MnO_2$ dotiert wurde, ist der Gleichstromwiderstand selbst nach 100 h unter ALT-Bedingungen unverändert.

```
Tab.2a : Piezoelektrische Eigenschaften vor der Polung
Zusammensetzung 1: Pb₀,₉₇La₀,₀₃Ti₀,₄₄Zr₀,₄₆Mg₀,₀₅W₀,₀₅O₃ mit
              0,8 mol-% MnO2
Zusammensetzung 1: Pb₀,₉₇La₀,₀₃Ti₀,₄₄Zr₀,₄₆Mg₀,₀₅W₀,₀₅O₃ mit
              1,6 mol-% MnO₂
```

|  | $\epsilon/\epsilon_0$ | tan δ | ϱ | Sinter-temp. | ALT |
|---|---|---|---|---|---|
| 1 | 1705 | 0,5 | 8,07 | 1100 | 0,1 |
| 2 | 1768 | 0,5 | 8,02 | 1100 | 100% |

Tab. 2b

| | $\varepsilon/\varepsilon_0$ | tan $\delta$ | $k_{31}$ | $d_{31}$ in $10^{-12}$m/V | k | Q |
|---|---|---|---|---|---|---|
| Piezoelektrische Eigenschaften nach der Polung | | | | | | |
| 1 | 2088 | 0,8 | 0,37 | 181 | 0.63 | 207 |
| 2 | 1594 | 0,5 | 0,35 | 142 | 0.58 | 595 |

Ausführungsbeispiel 2

Zur Herstellung eines Vielschichtaktuators werden zunächst grüne keramische Folien hergestellt. Dazu werden die kalzinierten Pulvermischungen wie oben beschrieben hergestellt. Diesen werden gegebenenfalls noch Sinterhilfsmittel zugesetzt. Diese keramischen Zusammensetzungen werden mit einem Lösungsmittel, vorzugsweise Wasser, und den entsprechenden Verflüssigern gemahlen und anschließend mit Bindern, Plastifizierern, Netzmittel und Trennmittel zu einem gießfähigen Schlicker gemischt.

Die Foliengießanlage besteht im Prinzip aus einem endlosen Stahlband, daß über zwei Rollen horizontal bewegt wird. Der Schlicker läuft aus einem Behälter am eine Ende des Gießbandes durch einen verstellbaren Spalt kontinuierlich auf das Stahlband. Durch Variation der Spalthöhe läßt sich die Dicke der Folien zwischen 0,2 und 1,5 mm variieren. Die Folie wird getrocknet, dann aufgewickelt oder gleich zu Folienkarten geschnitten.

Auf die grünen Folienkarten werden die inneren Elektroden aufgebracht, indem das Elektrodenmuster mit einer Metallisierungspaste im Siebdruck aufgebracht wird. Die Metallisierungspasten enthalten üblicherweise Silber- oder Palladiumlegierungen.

Die metallisierten Folienkarten werden gestapelt und mit einem Preßdruck von 300 MPa zu einer Platte laminiert. Die Platte wird einer Temperaturbehandlung unterworfen, bei der zunächst der Binder ausgeheizt wird und dann bei höheren Temperaturen die Keramik dichtgesintert wird. Typische Sinterbedingungen sind für die erfindungsgemäßen manganhaltigen Zusammensetzungen 1150°C, 2h Haltezeit, Aufheiz- und Abkühlgeschwindigkeit 320 °C/h. Fertig gesintert haben die keramischen Schichten eine Schichtdicke von 5 - 15 mm.

Die Platten werden in einzelne Halbprodukte zerschnitten. Die offenliegenden inneren Elektroden werden mit Endkon-takten versehen.

**Patentansprüche**

1.    Lanthan-Blei-Zirkon-Titan-Perowskit der allgemeinen Zusammensetzung
$Pb_{1-a}La_a (Mg_{x/2}W_{x/2})Ti_yZr_zO_3$,
mit

0,01 $\leq$ a $\leq$ 0,05,
0,01 $\leq$ x $\leq$ 0,06,
0,4 $\leq$ y $\leq$ 0,5 und
0,4 $\leq$ z $\leq$ 0,5,
wobei x + y + z = 1  ist,
mit einer Dotierung von 0,5 - 2 Mol-% $MnO_2$ .

2.    Komplexer substituierter Lanthan- Blei-Zirkon-Titan-Perowskit nach Anspruch 1,
dadurch gekennzeichnet,
daß a = 0,03 und x = 0,5 ist.

3.    Komplexer substituierter Lanthan-Blei-Zirkon-Titan-Perowskit nach Anspruch 1 oder 2,
dadurch gekennzeichnet,
daß die Dotierung 1,6 Mol-% $MnO_2$ ist.

4.    Keramische Zusammensetzung für piezoelektrische Bauelemente,
dadurch gekennzeichnet,
daß sie mindestens einen Lanthan- Blei-Zirkon-Titan-Perowskit nach der Erfindung und 0,1 bis 20 Mol-% eines bleihaltigen Sinterhilfsmittel enthält.

**5.** Aktuator, insbesondere mit Vielschichtstruktur, mit mindestens einer Schicht, die einen Lanthan-Blei-Zirkon-Titan-Perowskit nach der Erfindung enthält.

## Claims

1. A lanthanum-lead-zirconium-titanium perovskite having the general composition
$Pb_{1-a}La_a(Mg_{x/2}W_{x/2})Ti_yZr_zO_3$,
wherein

    $0.01 \leq a \leq 005$,
    $0.01 \leq x \leq 0.06$,
    $0.4 \leq y \leq 0.5$ and
    $0.4 \leq z \leq 0.5$,
    and $x + y + z = 1$,
    said perovskite being doped with 0.5-2 mol % $MnO_2$.

2. A complex, substituted lanthanum-lead-zirconium-titanium perovskite as claimed in Claim 1, characterized in that $a = 0.03$ and $x = 0.5$.

3. A complex, substituted lanthanum-lead-zirconium-titanium perovskite as claimed in Claim 1 or 2, characterized in that the dopant is $MnO_2$ in a quantity of 1.6 mol%.

4. A ceramic composition for piezoelectric components, characterized in that it comprises at least a lanthanum-lead-zirconium-titanium perovskite in accordance with the invention and 0.1 to 20 mol% of a lead-containing sintering aid.

5. An actuator, in particular an actuator having a multilayer structure, comprising at least one layer which contains a lanthanum-lead-zirconium-titanium perovskite in accordance with the invention.

## Revendications

1. Pérovskite de plomb-lanthane-zirconium-titane de composition générale :
$Pb_{1-a}La_a(Mg_{x/2}W_{x/2})Ti_yZr_zO_3$,
avec

    $0,01 \leq a \leq 0,05$
    $0,01 \leq x \leq 0,06$
    $0,4 \leq y \leq 0,5$, et
    $0,4 \leq z \leq 0,5$
    où $x + y + z = 1$
    avec une dotation de 0,5 - 2% en mole de $MnO_2$.

2. Pérovskite complexe substituée lanthane-plomb-zirconium-titane selon la revendication 1, caractérisée en ce

    que $a = 0,03$ et $x = 0,5$.

3. Pérovskite complexe substituée lanthane-plomb-zirconium-titane selon l'une des revendications 1 ou 2, caractérisée en ce

    que la dotation est de 1,6% en mole de $MnO_2$.

4. Composition céramique pour modules piézo-électriques, caractérisée en ce

    qu'elle contient au moins une pérovskite de lanthane-plomb-zirconium-titane selon l'invention et 0,1% à 20% en mole d'un adjuvant de frittage contenant du plomb.

5. Actionneur, en particulier avec une structure à couche multiple, doté d'au moins une couche qui contient une pérovskite de lanthane-plomb-zirconium-titane selon l'invention.